# EUROPEAN PATENT APPLICATION

(11) **EP 4 401 526 A1**
(43) Date of publication of application: **17.07.2024**
(21) Application number: 23191023.3
(22) Date of filing: 11.08.2023
(51) Int. Cl.: H10B 43/27, H10B 41/27, H10B 41/10, H10B 43/10

(54) **NON-VOLATILE MEMORY DEVICE, METHOD FOR FABRICATING THE SAME AND ELECTRONIC SYSTEM INCLUDING THE SAME**

(30) Priority: 10.01.2023 KR 20230003617
(71) Applicant: Samsung Electronics Co., Ltd., Suwon-si, Gyeonggi-do 16677 (KR)
(72) Inventor: LEE, Jung-Hwan, Suwon-si (KR); CHO, Hyunmin, Suwon-si (KR)
(74) Representative: Marks & Clerk LLP

(57) **Abstract**

A non-volatile memory device may include a channel structure including a first stacking structure (GS1), a second stacking structure (GS2), a first channel structure (CH1) penetrating the first stacking structure (GS1), and a second channel structure (CH2) penetrating the second stacking structure (GS2). The second channel structure (CH2) includes a first portion (P1) having a width that decreases or is maintained as the first portion (P1) extends toward a substrate (101), and a second portion (P2) having a width that increases as the second portion (P2) extends toward the substrate (101).

## Description

### BACKGROUND

### 1. Field of the Disclosure

The disclosure relates to a non-volatile memory device, a method for fabricating the same, and an electronic system including the same.

### 2. Description of the Related Art

In an electronic system that requires data storage, a semiconductor device capable of storing high-capacity data may be required. Accordingly, a method capable of increasing the data storage capacity of a semiconductor device is being researched. For example, as one of the methods for increasing the data storage capacity of a semiconductor device, a semiconductor device including three-dimensionally arranged memory cells instead of two-dimensionally arranged memory cells has been proposed.

### SUMMARY

One of the technical objects to be achieved by the technical idea of the present disclosure is to provide a non-volatile memory device including three-dimensionally arranged memory cell structures.

One of the technical objects to be achieved by the technical idea of the present disclosure is to provide a method for fabricating a non-volatile memory device.

One of the technical objects to be achieved by the technical idea of the present disclosure is to provide an electronic system including a non-volatile memory device.

A non-volatile memory device, as manifested in one or more embodiments of the inventive concept, includes: a first stacking structure including first gate electrodes and first interlayer insulating layers alternately stacked on at least a portion of a substrate; a second stacking structure including second gate electrodes and second interlayer insulating layers alternately stacked on at least a portion of the first stacking structure; and a channel structure including a first channel structure penetrating the first stacking structure, and a second channel structure connected to the first channel structure and penetrating the second stacking structure, wherein the second channel structure includes a first portion having a width that narrows or is maintained as the first portion extends toward the substrate, and a second portion having a width that increases as to the second portion extends toward the substrate in an area overlapping a lowermost one of the second gate electrodes that is disposed closest to the substrate in a vertical direction to the substrate.

The second stacking structure may have a thickness, in a direction perpendicular to a surface of the substrate, that is different from a thickness of the first stacking structure.

The second channel structure may include the second portion of which the width increases as it extends toward the substrate in the area overlapping a lower second gate electrode most adjacent to the lowermost second gate electrode in a vertical direction to the substrate.

The second stacking structure may be disposed on a first capping insulation layer on the first stacking structure.

A cross-sectional thickness of the first capping insulation layer interposed between an uppermost one of the first gate electrodes of the first stacking structure and the lowermost one of the second gate electrodes of the second stacking structure may be greater than a thickness of a given one of the first interlayer insulating layers or a given one of the second interlayer insulating layers.

The channel structure may include a third portion having a width that increases as it extends toward the substrate.

The first portion of the channel structure may be disposed on or under the third portion of the channel structure.

A widest width of the second portion of the channel structure may be less than a widest width of the third portion of the channel structure.

A widest width of the second portion of the channel structure may be greater than the widest width of the third portion of the channel structure.

The channel structure may include a channel layer. A thickness of the channel layer in the second portion of the channel structure may be different from a thickness of the channel layer in the first or third portions of the channel layer.

The non-volatile memory device may additionally include a common source line disposed on at least a portion of the substrate.

The common source line may be connected to the channel layer.

The non-volatile memory device may include two or more second stacking structures stacked on the first stacking structure in a direction perpendicular to a surface of the substrate.

The non-volatile memory device may include the first channel structure of the channel structure penetrating the first stacking structure is connected to a plurality of second channel structures of the channel structure penetrating the two or more second stacking structures.

Each of the plurality of second channel structures may include a first portion having a width that narrows or is maintained as the first portion extends toward the substrate, and a second portion having a width that increases as the second portion extends toward the substrate in the area overlapping the lowermost one of the second gate electrodes that is disposed closest to the substrate in the vertical direction to the substrate.

A peripheral circuit substrate, a peripheral circuit pattern disposed on the peripheral circuit substrate, and a peripheral area insulation layer on the peripheral circuit pattern may be disposed under the substrate.

In accordance with another embodiment, a method for fabricating a non-volatile memory device may include: forming a first dummy mold structure in which first sacrificial insulation layers and first interlayer insulating layers are alternately stacked on at least a portion of a substrate; forming a vertical structure penetrating the first dummy mold structure; forming a second dummy mold structure in which second sacrificial insulation layers and second interlayer insulating layers are alternately stacked on the first dummy mold structure and the vertical structure; and forming a penetration hole (i.e., opening) in the second dummy mold structure for forming a channel structure by exposing an upper surface of the vertical structure through the penetration hole and removing the vertical structure, wherein the vertical structure includes a sacrificial metal layer and a sacrificial barrier metal layer on at least part of an upper surface of the sacrificial metal layer, and the forming of the penetration hole for forming the channel structure may include supplying an etching gas capable of forming a by-product for etching the second sacrificial insulation layer by reacting with the sacrificial barrier metal layer.

In the forming of the second dummy mold structure, after forming the second dummy mold structure, the process for forming a vertical structure penetrating the second dummy mold structure and again forming another second dummy mold structure on the second dummy mold structure and the vertical structure may be repeatedly performed.

The second sacrificial insulation layer may include a silicon nitride.

The sacrificial barrier metal layer may include titanium.

The etching gas may include fluorine.

In accordance with another embodiment, an electronic system includes: a semiconductor device on a main substrate; and a controller electrically connected to the semiconductor device on the main substrate, wherein the semiconductor device includes a non-volatile memory device including a substrate, a peripheral circuit substrate disposed under the substrate, a peripheral circuit pattern disposed on the peripheral circuit substrate, a peripheral area insulation layer on the peripheral circuit pattern, a first stacking structure including first gate electrodes and first interlayer insulating layers alternately stacked on the substrate, a second stacking structure including second gate electrodes and second interlayer insulating layers alternately stacked on the first stacking structure, and a channel structure including a first channel structure penetrating the first stacking structure, and a second channel structure connected to the first channel structure and penetrating the second stacking structure, wherein the second channel structure includes a first portion having a width that decreases or is maintained as the first portion extends toward the substrate, and a second portion having a width that increases as the second portion extends toward the substrate in an area overlapping the lowermost second gate electrode that is closest to the substrate in a horizontal direction to the substrate, and an input and output pad electrically connected to the peripheral circuit pattern of the non-volatile memory device.

The non-volatile memory device may further include a common source line on the substrate, channel pads on the channel structures, channel contact plugs on the channel pads, a bit line on the channel contact plugs, and gate contact plugs connected to corresponding ones of the first and second gate electrodes.

The non-volatile memory device according to an embodiment, in the structure including a plurality of stacking structures, increases the width of the penetration hole for the channel structure at the portion where adjacent stacking structures are joined, thereby it is possible to fundamentally solve problems caused by too narrow a width at the portion where the penetration hole for forming a plurality of channel structures is connected or problems caused by a misalignment of the channel structures penetrating a plurality of stacking structures.

At least some of the above and other features of the invention are set out in the claims.

### BRIEF DESCRIPTION OF THE DRAWINGS

Embodiments will be more clearly understood from the following detailed description taken in conjunction with the accompanying drawings, wherein like reference numerals (when used) indicate corresponding elements throughout the several views, and in which:
FIG. 1 is a top plan view of at least a portion of an example non-volatile memory device according to an embodiment, and FIG. 2 is a cross-sectional view of the example non-volatile memory device of FIG. 1 cut along a line I-I'.
FIG. 3 is an enlarged cross-sectional view showing a close-up of a channel structure CH of the non-volatile memory device of FIG. 2, and FIG. 4, FIG. 5 and FIG. 6 are enlarged cross-sectional views showing a channel structure according to an embodiment different from FIG. 3.
FIG. 7 to FIG. 14 are cross-sectional views for explaining intermediate processes in an example method for fabricating a non-volatile memory device according to embodiments.
FIG. 15 is a view schematically showing an example electronic system including a semiconductor device according to an embodiment.
FIG. 16 is a perspective view schematically illustrating an example electronic system including a semiconductor device according to an embodiment.
FIG. 17 and FIG. 18 are cross-sectional views showing an example semiconductor package according to embodiments.

### DETAILED DESCRIPTION

In the following detailed description, only certain embodiments of the present disclosure have been shown and described, simply by way of illustration and without limitation or loss of generality. As those skilled in the art would realize given the teachings herein, the described embodiments may be modified in various different ways, all without departing from the scope of the present disclosure.

Accordingly, the drawings and description are to be regarded as illustrative in nature and not restrictive. Like reference numerals designate like elements throughout the specification and throughout the several views of the accompanying drawings.

In addition, expressions written in the singular may be construed in the singular or plural unless an explicit expression such as "one" or "single" is used. Terms including ordinal numbers such as first, second, and the like will be used only to describe various components, and are not to be interpreted as limiting these components. These terms may be used for the purpose of distinguishing one constituent element from other constituent elements and are not intended to convey a particular order of elements, unless specifically designated as such.

Hereinafter, embodiments of the present disclosure are described with reference to the accompanying drawings as follows.

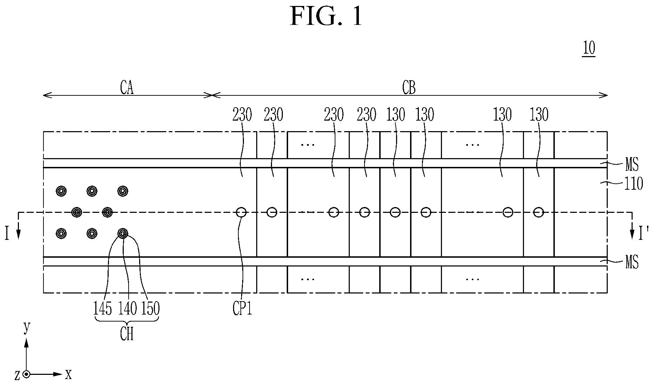

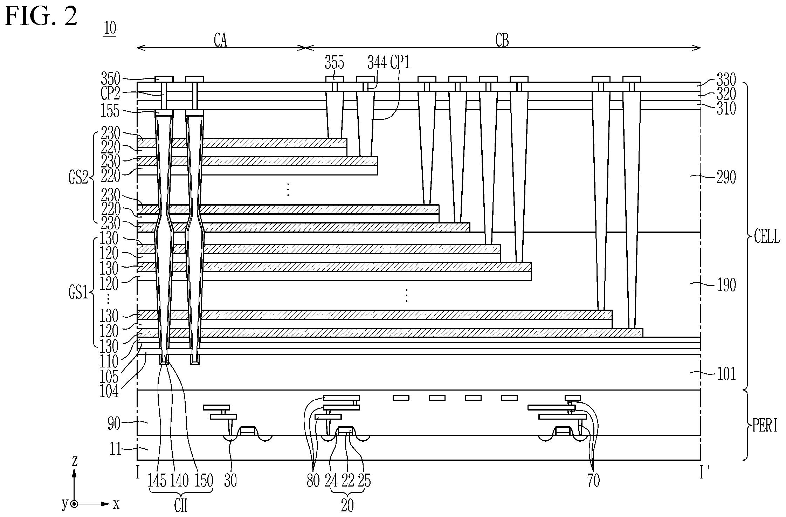

FIG. 1 is a top plan view of at least a portion of an example non-volatile memory device 10 according to an embodiment. FIG. 1 is the top plan view corresponding to an upper surface of an uppermost second gate electrode 230 of a memory cell area CELL of FIG. 2, and a second capping insulation layer 290 is omitted in a connection area CB.

FIG. 2 is a cross-sectional view of the example non-volatile memory device 10 shown in FIG. 1, cut along a line I-I' of FIG. 1.

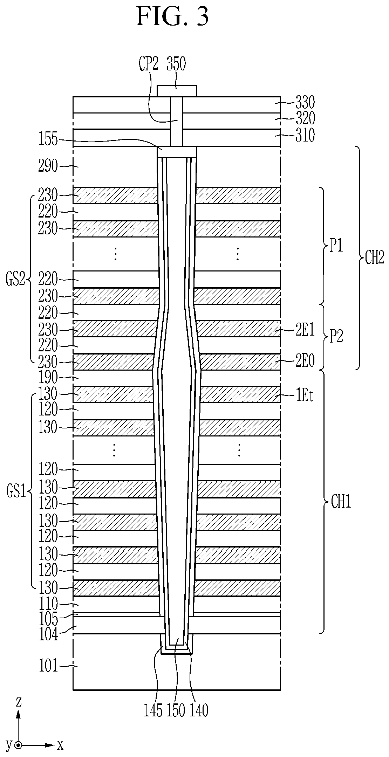

FIG. 3 is an enlarged cross-sectional view showing a close-up of a channel structure CH of the example non-volatile memory device of FIG. 2.

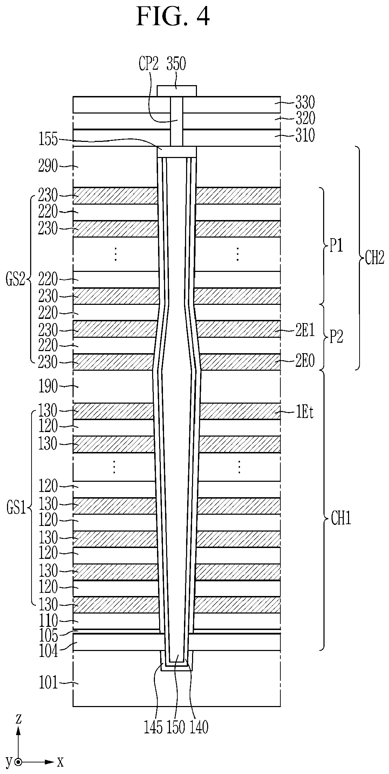

FIG. 4 to FIG. 6 are enlarged cross-sectional views showing a channel structure according to a different embodiment from FIG. 3. FIG. 3 to FIG. 6 show a portion of an area corresponding to a cross-section taken along a line I-I' of FIG. 1.

Referring to FIG. 1 and FIG. 2, the non-volatile memory device 10 may include a memory cell area CELL and a peripheral circuit area PERI. The memory cell area CELL can be disposed on top of the peripheral circuit area PERI in a z direction (vertical). Conversely, in some embodiments, the memory cell area CELL may be disposed at the bottom of the peripheral circuit area PERI.

The peripheral circuit area PERI may include a first substrate 11, and circuit elements 20, circuit contact plugs 70, and/or circuit wire lines 80 disposed on the first substrate 11.

The first substrate 11 may have an upper surface extending in a first direction (an x direction) and a second direction (a y direction). The first substrate 11 may include a semiconductor material, for example, but not limited to, a group IV semiconductor, a group III-V compound semiconductor, or a group II-VI compound semiconductor.

In the first substrate 11, separate element isolation layers may be formed so that an active area may be defined.

Source/drain areas 30 including impurities may be disposed in a part of the active area.

The circuit elements 20 may include a horizontal (i.e., lateral) transistor. Each of the circuit elements 20 may include a circuit gate dielectric layer 22, a spacer layer 24, and a circuit gate electrode 25. The source/drain areas 30 may be disposed within the first substrate 11 on both sides of the circuit gate electrode 25.

A peripheral area insulation layer 90 may be disposed on the circuit elements 20 on at least a portion of the first substrate 11. The circuit contact plugs 70 may pass through the peripheral area insulation layer 90 (in a z direction) and be connected to the source/drain areas 30. An electrical signal may be applied to the circuit element 20 via the circuit contact plugs 70. In an area not explicitly shown, the circuit contact plugs 70 may also be connected to the circuit gate electrode 25. The circuit wire lines 80 may be connected to the circuit contact plugs 70 and may be disposed as a plurality of layers.

The memory cell area CELL may include a second substrate 101 and memory cell structures. The memory cell area CELL may include capping insulation layers 190 and 290, upper insulation layers 310, 320, and 330, gate contact plugs CP1, channel contact plugs CP2, a bit line 350, and upper wires 355.

The second substrate 101 may include a cell array area CA in which memory cell structures are disposed and a connection area CB for connecting gate electrodes of the memory cell structures with corresponding upper wires.

The connection area CB may be disposed in at least one direction, for example, the first direction (the x direction) of the cell array area CA, or may be disposed along the edge of the cell array area CA.

The second substrate 101 may have an upper surface extending in the first direction (the x direction) and the second direction (the y direction). The second substrate 101 may include a semiconductor material, for example, but not limited to, a group IV semiconductor, a group III-V compound semiconductor, or a group II-VI compound semiconductor. For example, a group IV semiconductor may include silicon, germanium, or silicon-germanium. The second substrate 101 may be made of, for example, polycrystalline silicon, and may or may not include an impurity.

The memory cell structures may be disposed side by side to be spaced apart from each other on the second substrate 101. However, the number and/or the arrangement of the memory cell structures disposed on the second substrate 101 may be variously changed. Hereinafter, one illustrative memory cell structure will be described, according to one or more embodiments.

The memory cell structure may include memory stacking structures GS1 and GS2, channel structures CH, first and second conductive layers 104 and 105, and separation structures MS. The memory stacking structures GS1 and GS2 may include 2 or more stacking structures. The two or more stacking structures may be spaced apart from each other and disposed in a third direction (a z direction) by a capping insulation layer (e.g., first and second capping insulation layers 190 and 290 of FIG. 2). In this specification, the stacking structure disposed closest to the substrate (in the z direction) among the stacking structures is referred to as a first stacking structure, and one or more stacking structures disposed on the first stacking structure are referred to as a second stacking structure or second stacking structures.

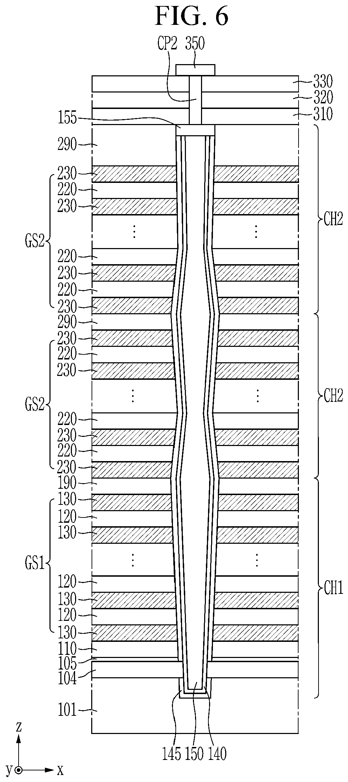

Referring to FIG. 2 to FIG. 5, the memory stacking structures GS1 and GS2 may include a first stacking structure GS1 disposed on the second substrate 101 and a second stacking structure GS2 disposed on the first stacking structure GS1. In some embodiments, the memory stacking structures GS1 and GS2 may include three or more stacking structures, unlike the embodiments as shown in FIG. 2 to FIG. 5. As an example, as shown in FIG. 6, the memory stacking structures GS1 and GS2 may include a first stacking structure GS1 disposed on the second substrate 101 and two second stacking structures GS2 sequentially stacked (in the z direction) on the first stacking structure GS1.

The first stacking structure GS1 includes first gate electrodes 130 and first interlayer insulating layers 120 alternately stacked (in the z direction) on at least a portion of the second substrate 101. The second stacking structure GS2 includes second gate electrodes 230 and second interlayer insulating layers 220 alternately stacked (in the z direction) on at least a portion of the first stacking structure GS1.

The first and second gate electrodes 130 and 230 may be vertically spaced apart from each other and disposed (stacked) on the second substrate 101. The first and second gate electrodes 130 and 230 may include one or a plurality of lower gate electrodes, a plurality of middle gate electrodes, and one or a plurality of upper gate electrodes.

One or a plurality of lower gate electrodes may include a gate electrode of a ground selection transistor. One or a plurality of upper gate electrodes may include a gate electrode of a string selection transistor. The plurality of middle gate electrodes may be the gate electrodes of the memory cell transistors. The number of first and second gate electrodes 130 and 230 constituting the memory cells may be determined according to the capacity of the non-volatile memory device 10.

The first and second gate electrodes 130 and 230 may extend to different lengths from the cell array area CA to the connection area CB (i.e., in the x direction) to have a stepped structure. In the first and second gate electrodes 130 and 230, the lower gate electrode may extend longer than the upper gate electrode by the stair structure, and may include ends that are not covered by the first and second interlayer insulating layers 120 and 220.

In some embodiments, a certain number of the first and second gate electrodes 130 and 230, for example, two, four, or six gate electrodes, may form one gate group, and the stair structure may be formed between the gate groups along the first direction (the x direction). The gate electrodes constituting one gate group may also be disposed to have the stair structure in the second direction (the y direction).

As shown in FIG. 1, the first and second gate electrodes 130 and 230 may be spaced apart from the first and second gate electrodes 130 and 230 adjacent in the second direction (the y direction) by a pair of separation structures MS extending in the first direction (the x direction).

The first and second gate electrodes 130 and 230 may include a metallic material, for example, but not limited to, tungsten (W). According to some embodiments, the first and second gate electrodes 130 and 230 may include, for example, a polycrystalline silicon or a metal silicide material. In embodiments, the first and second gate electrodes 130 and 230 may further include a diffusion barrier layer, for example, the diffusion barrier layer may include tungsten nitride (WN), tantalum nitride (TaN), titanium nitride (TiN), or combination thereof.

The first and second interlayer insulating layers 120 and 220 may be respectively disposed between the first and second gate electrodes 130 and 230. Like the first and second gate electrodes 130 and 230, the first and second interlayer insulating layers 120 and 220 may also be spaced apart from each other in a vertical direction on at least a portion of the upper surface of the second substrate 101 and extend in at least one direction. The first and second interlayer insulating layers 120 and 220 may include an insulating material such as, for example, a silicon oxide or a silicon nitride.

Referring to FIG. 4, in some embodiments, the thickness of the first capping insulation layer 190 interposed between an uppermost first gate electrode 1 Et of the first stacking structure GS1 and a lowermost second gate electrode 2E0 of the second stacking structure GS2 may be thicker than the thickness of the first interlayer insulating layer 120 or the second interlayer insulating layer 220. However, it is not limited thereto, and as shown in FIG. 3, the thickness of the first capping insulation layer 190 interposed between the uppermost first gate electrode 1Et and the lowermost second gate electrode 2E0 may be the same as the thickness of the first interlayer insulating layer 120 or the second interlayer insulating layer 220.

In some embodiments, when the memory stacking structures GS1 and GS2 includes three or more stacking structures, the thickness of the second capping insulation layer 290 interposed between the uppermost second gate electrode of the underlying second stacking structure GS2 and the lowermost second gate electrode of the overlying second stacking structure GS2 among a plurality of second stacking structures GS2 may be thicker than the thickness of the second interlayer insulating layer 220.

In one or more embodiments, the second stacking structure GS2 may have a thickness (in the z direction) that is the same as or different from a thickness of the first stacking structure GS1. In some embodiments, when the memory stacking structures GS1 and GS2 include three or more stacking structures, the heights of the three or more stacking structures may be the same as or different from each other. In one example, the second stacking structure GS2 may be stacked at a different height from the first stacking structure GS1. When the memory stacking structures GS1 and GS2 include three or more stacking structures, at least two of three or more stacking structures may have different heights.

The first and second conductive layers 104 and 105 may be stacked and disposed on at least a portion of the upper surface of the second substrate 101. At least a part of the first and second conductive layers 104 and 105 may function as a part of a common source line of the non-volatile memory device 10, and may function as a common source line together with the second substrate 101.

The first and second conductive layers 104 and 105 may include a semiconductor material, such as, for example, polycrystalline silicon. In this case, at least the first conductive layer 104 may be a doped layer, and the second conductive layer 105 may be a doped layer or a layer including an impurity diffused from the first conductive layer 104.

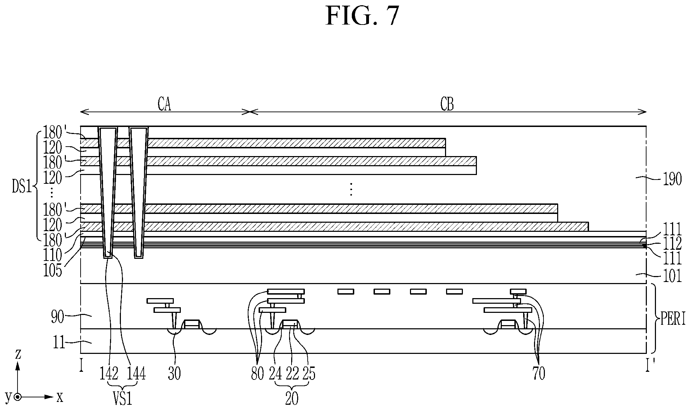

Although not explicitly shown, on the second substrate 101 in the connection area CB, first and second source sacrificial layers 111 and 112 (see FIG. 7) may partially remain without being replaced with the first conductive layer 104. The first and second source sacrificial layers 111 and 112 may not substantially perform the functions in the non-volatile memory devices 10.

The channel structures CH may constitute one memory cell string, respectively, and may be spaced apart and disposed while forming rows and columns on the cell array area CA of the second substrate 101. The channel structures CH may be disposed to form a lattice fringe or a zigzag in one direction.

In some embodiments, dummy channels that do not substantially constitute the memory cell string may be disposed at the end of the cell array area CA adjacent to the connection area CB and in the connection area CB.

Within the channel structures CH, the channel layer 140 may be disposed. In the channel structures CH, the channel layer 140 may be formed in an annular shape surrounding an internal channel insulation layer 150. The term "surrounding" (or "surrounds" or "surrounded") as may be used herein is intended to broadly refer to a component, structure or layer that envelops, encircles, or encloses another component, structure or layer on all sides, although breaks or gaps may also be present. Thus, for example, a material layer having voids or gaps therein may still "surround" another layer which it encircles. In some embodiments, the channel layer 140 may have a column shape, extending in the z direction, such as a cylinder or a prism without the channel insulation layer 150. The channel layer 140 may include a semiconductor material such as, for example, polycrystalline silicon or monocrystalline silicon.

The gate dielectric layer 145 may be disposed between the first and second gate electrodes 130 and 230, and the channel layer 140.

Although not explicitly shown, the gate dielectric layer 145 may include a tunneling layer, an information storage layer, and a blocking layer, which are sequentially accumulated (i.e., stacked) from the channel layer 140. The tunneling layer may tunnel a charge to the information storage layer, for example, and may include silicon oxide (SiO₂), silicon nitride (Si₃N₄), silicon oxynitride (SiON) or combinations thereof. The information storage layer may be a charge trap layer or a floating gate conductive layer. The blocking layer may include, for example, silicon oxide (SiO₂), silicon nitride (Si₃N₄), silicon oxynitride (SiON), a high dielectric constant (high-k) dielectric material, or combinations thereof.

As shown in FIG. 2 and the enlarged cross-sectional view of FIG. 3, in some embodiments, the channel layer 140 may be connected to the first conductive layer 104. The first conductive layer 104 may pass through at least a portion of the gate dielectric layer 145 of the channel structure and be in contact with the sidewall of the channel layer 140.

However, in some other embodiments, the channel layer 140 may be connected to the second substrate 101. More specifically, the channel structures CH may include an epitaxial layer connected to the second substrate 101 at the bottom. The epitaxial layer may be connected to the channel layer 140. In this case, the non-volatile memory device 10 may not include the first and second conductive layers 104 and 105.

The channel structure CH may be connected to the second substrate 101 by vertically penetrating the memory stacking structures GS1 and GS2. The term "penetrating," as may be used herein, is intended to broadly refer to a structure extending at least partially through a surface and/or material layer in a direction that is substantially perpendicular to a surface (e.g., upper surface) of the second substrate 101 (i.e., z direction or vertical direction). The channel structure CH, as shown in FIG. 3 to FIG. 6, may include a second channel structure CH2 stacked on the first channel structure CH1 in the z direction (i.e., vertical direction). In some embodiments, the channel structure CH, as shown in FIG. 6, may include two second channel structures CH2 stacked sequentially on the first channel structure CH1 in the z direction.

The channel structure CH has a form in which the first channel structure CH1 penetrating the first stacking structure GS1 and the second channel structure CH2 penetrating the second stacking structure GS2 are connected. In some embodiments, when two or more second stacking structures GS2 are stacked on the first stacking structure GS1, the first channel structure CH1 and two or more second channel structures CH2 may have a connected form.

The first channel structure CH1 may have a column shape extending in the z direction. As the first channel structure CH1 extends towards the second substrate 101, the width may have a narrower or maintained shape.

The second channel structure CH2 may have a column shape extending in the z direction. The second channel structure CH2 includes a first portion P1 of which a width is narrowed or maintained as it extends toward the second substrate 101, and a second portion P2 whose width increases as it extends toward the second substrate 101 in an area overlapping the lowermost second gate electrode 2E0 disposed closest to the second substrate 101 in the vertical direction to the second substrate 101.

In some embodiments, when stacking two or more second stacking structures GS2 on the first stacking structure GS1, each of two or more second channel structures CH2 may include a first portion P1 of which a width is narrowed or maintained as it extends toward the second substrate 101, and a second portion P2 whose width increases as it extends toward the second substrate 101 in the area overlapping the lowermost second gate electrode 2E0 disposed closest to the second substrate 101 in the vertical direction to the second substrate 101.

The width may be measured in the direction parallel to the second substrate 101 (i.e., x and/or y directions). If the cross-section of the channel structure CH in the first and second directions (the x and y directions) is not a circle, the width may mean the widest width measured in a direction parallel to the second substrate 101.

According to some embodiments, as shown in FIG. 3, the second channel structure CH2 includes the second portion P2 of which the width increases as it extends closer to the second substrate 101 in the area overlapping the lower second gate electrode 2E1 disposed closest to the lowermost second gate electrode 2E0 in the direction parallel to the second substrate 101 (i.e., x and/or y directions).

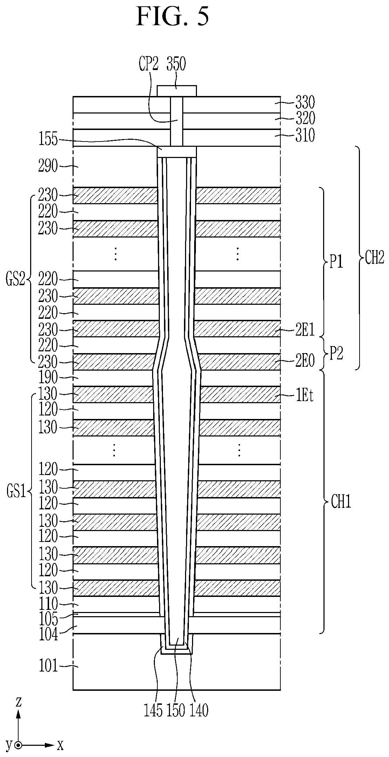

According to other embodiments, as shown in FIG. 5, the second channel structure CH2 includes the second portion P2 of which the width increases as it extends closer to the second substrate 101 in the area overlapping the lowermost second gate electrode 2E0 in the direction parallel to the second substrate 101.

The channel structure CH may include a third portion (not explicitly shown, but implied) whose width increases as it approaches the second substrate 101. The third portion may refer to a portion where the width of the channel structure CH is widened due to bowing which may inevitably be caused by an etching process.

The third portion may be generated at any position of the first channel structure CH1 and the second channel structure CH2. In some embodiments, the second channel structure CH2 may include a third portion. At this time, the first portion P1 of the second channel structure CH2 may be disposed above or below the third portion.

The widest width of the second portion P2 of the second channel structure CH2 may be narrower or wider than the widest width of the third portion due to the bowing.

The first portion P1 and the second portion P2 may be connected through an inflection portion in which a lateral profile of the second channel structure CH2 changes.

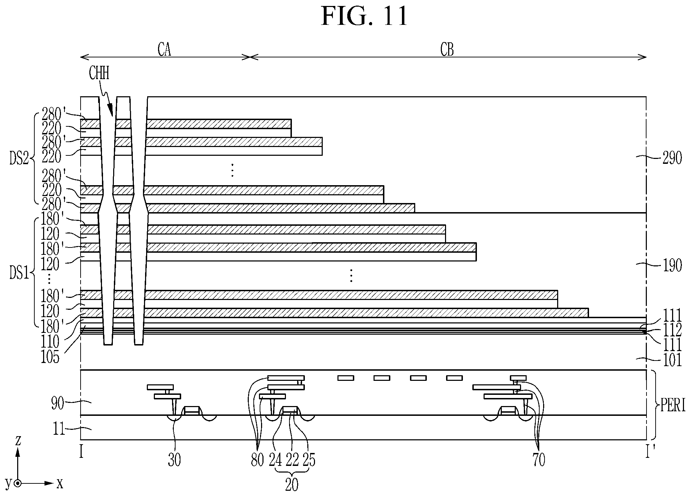

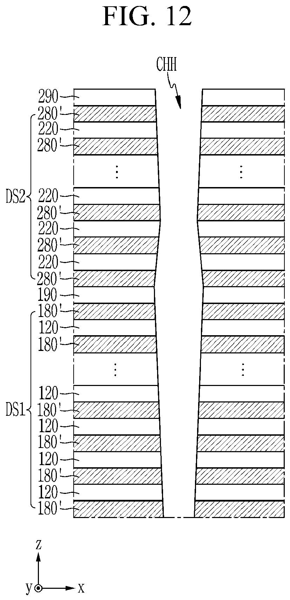

As the second channel structure CH2 includes the first and second portions P1 and P2, the wide width is formed on the junction between the first stacking structure GS1 and the second stacking structure GS2 (or the junction of a plurality of second stacking structures GS2 when including a plurality of second stacking structures GS2). As a result, at the portion where a plurality of stacking structures GS1 and GS2 are joined, it is possible to fundamentally solve a problem caused by too narrow a penetration hole (i.e., opening) CHH (see FIGS. 11 and 12) for forming the channel structure or a problem caused by misalignment of the channel structures CH penetrating a plurality of stacking structures GS1 and GS2.

The channel layer 140, the gate dielectric layer 145, and the channel insulation layer 150 may be connected to each other between the first channel structure CH1 and the second channel structure CH2.

In some embodiments, the thickness of the channel layer 140 of the second portion P2 of the second channel structure CH2 may be the same as or different from the thickness of the channel layer 140 of the first portion P1. The thickness of the channel layer 140 of the second portion P2 of the second channel structure CH2 may be the same as or different from the thickness of the channel layer 140 of the third portion due to bowing. In some embodiments, the thickness of the channel layer 140 of the second portion P2 of the second channel structure CH2 may be different from the thickness of the channel layer 140 of the first portion P1. The thickness of the channel layer 140 of the second portion P2 of the second channel structure CH2 may be different from the thickness of the channel layer 140 of the third portion.

The channel pads 155 may be disposed on the channel layer 140 in the channel structures CH. The channel pad 155 may not be disposed on the upper of the first channel structure CH1 on the bottom, and may be disposed only on the upper of the second channel structure CH2 on the top. In some embodiments, when the channel structure CH includes a plurality of second channel structures CH2, the channel pad 155 may be disposed only on the upper of the uppermost second channel structure CH2.

Channel pads 155 may be disposed on the channel structure CH to cover the upper surface of the channel insulation layer 150 and be electrically connected to the channel layer 140. In some embodiments, as shown in FIG. 2 and FIG. 3, the channel pad 155 may be disposed on the channel layer 140, the gate dielectric layer 145, and the channel insulation layer 150. However, in other embodiments, the channel pad 155 may disposed on the channel layer 140 and the channel insulation layer 150, and the sidewall of the channel pad 155 may be surrounded by the gate dielectric layer 145.

The channel pads 155 may include, for example, doped polycrystalline silicon, although embodiments of the invention are not limited thereto.

The separation structures MS, as shown in FIG. 1, may penetrate the memory stacking structures GS1 and GS2 along the third direction (the z direction). The separation structures MS may separate the memory stacking structures GS1 and GS2 in the second direction (the y direction).

The separation structures MS may extend along the first direction (the x direction) from the cell array area CA to the connection area CB. The separation structures MS may pass through the first and second gate electrodes 130 and 230 along the third direction (the z direction) to be in contact with the second substrate 101. The separation structures MS may be formed by partially recessing the upper part of the second substrate 101 or be disposed on the second substrate 101 so as to be in contact with the upper surface of the second substrate 101. The separation structures MS may include an insulating material, for example, a silicon oxide, a silicon nitride, or a combination thereof.

The capping insulation layers 190 and 290 may include a first capping insulation layer 190 covering (i.e., on) the first stacking structure GS1 and a second capping insulation layer 290 covering the second stacking structure GS2. The first capping insulation layer 190 and the second capping insulation layer 290 may include an insulating material, for example a silicon oxide.

The upper insulation layers 310, 320, and 330 may include a first upper insulation layer 310, a second upper insulation layer 320, and a third upper insulation layer 330 sequentially stacked on the second capping insulation layer 290 in the z direction. The upper insulation layers 310, 320, and 330 may include an insulating material such as, for example, a silicon oxide.

The gate contact plugs CP1 may be electrically connected to the first and second gate electrodes 130 and 230, respectively, in the connection area CB. The gate contact plugs CP1 may be connected to the first and second gate electrodes 130 and 230 exposed upwardly by passing through the first and second upper insulation layers 310 and 320 and the first and second capping insulation layers 190 and 290 in the connection area CB. The gate contact plugs CP1 may at least partially recess the first and second gate electrodes 130 and 230, and may be connected to the first and second gate electrodes 130 and 230. The gate contact plugs CP1 may be connected to the upper wires 355 by being connected to contact plugs 344. The gate contact plugs CP1 may include a conductive material, for example, tungsten (W), copper (Cu), aluminum (Al), and the like. The gate contact plugs CP1 may further include a diffusion barrier layer.

The channel contact plugs CP2 may be electrically connected to the channel structures CH in the cell array area CA. The channel contact plugs CP2 may be connected to the channel pads 155 of the channel structures CH through first to third upper insulation layers 310, 320, and 330, respectively, in the cell array area CA. The bit line 350 electrically connected to the channel contact plugs CP2 may be disposed on the channel contact plugs CP2. The channel contact plugs CP2 may include a conductive material.

The upper wires 355 may constitute a wire structure electrically connected to the memory cells in the memory cell area CELL. The upper wires 355 may be electrically connected to the first and second gate electrodes 130 and 230, for example. The number of the contact plugs and the wire lines constituting the wire structure may be variously changed in embodiments. The upper wires 355 may include a conductive material.

FIG. 7 to FIG. 14 are cross-sectional views to explain intermediate processes in at least a portion of an example method for fabricating the non-volatile memory device 10 including the memory stacking structures GS1 and GS2 in which one second stacking structure GS2 is stacked on the first stacking structure GS1 of FIG. 2, according to one or more embodiments of the invention. Hereinafter, the method for fabricating the non-volatile memory device including two stacking structures GS1 and GS2 is described, but a non-volatile memory device including three or more stacking structures may be manufactured by repeatedly performing some manufacturing steps among the method for fabricating the non-volatile memory device.

FIG. 7 to FIG. 14 show the area corresponding to the cross-section taken along a line I-I' of FIG. 1 to explain the method for fabricating the non-volatile memory device, respectively.

Referring to FIG. 7, a peripheral circuit pattern including circuit elements 20, circuit contact plugs 70, and circuit wire lines 80 may be disposed on at least a portion of a first substrate 11. A second substrate 101 may be disposed on at least a portion of an upper surface of the first substrate 11. First and second source sacrificial layers 111 and 112 may be alternatively stacked, in the z direction on at least a portion of the second substrate 101. A second conductive layer 105 may be formed on at least a portion of the alternating stack of first and second sacrificial layers 111, 112, and first sacrificial insulation layers 180' and first interlayer insulating layers 120 may be alternately stacked on at least a portion of the second conductive layer 105. A first capping insulation layer 190 may be formed, and a first vertical structure VS1 penetrating the first sacrificial insulation layers 180' and the first interlayer insulating layers 120 may be formed.

First, a circuit gate dielectric layer 22 and a circuit gate electrode 25 may be sequentially formed on the first substrate 11. The circuit gate dielectric layer 22 and the circuit gate electrode 25 may be formed by using, for example, atomic layer deposition (ALD) or chemical vapor deposition (CVD). The circuit gate dielectric layer 22 may be formed of an oxide, such as a silicon oxide, and the circuit gate electrode 25 may be formed of at least one of a polycrystalline silicon and a metal silicide layer, but is not limited thereto. The phrase "at least one of A and B," as may be used herein, is intended to refer to element A alone, element B alone, or elements A and B together. Next, a spacer layer 24 and source/drain areas 30 may be formed on both sidewalls of the circuit gate dielectric layer 22 and the circuit gate electrode 25. According to some embodiments, the spacer layer 24 may include a plurality of layers. Next, an ion implantation process may be performed to form the source/drain areas 30.

Among the lower wire structures, the circuit contact plugs 70 may be formed by forming a part of the peripheral area insulation layer 90, then etching the part to be removed and filling the removed peripheral area insulation layer 90 with conductive material. As may be used herein, the term "fill" or "filled" is intended to refer to either completely filling a defined space (e.g., etched portion of the peripheral area insulation layer 90) or partially filling the defined space; that is, the defined space need not be entirely filled but may, for example, be partially filled or have voids or other spaces throughout. The circuit wire lines 80, for example, may be formed by depositing a conductive material and then patterning it (e.g., using photolithography and etching processes).

The peripheral area insulation layer 90 may include a plurality of insulation layers. The peripheral area insulation layer 90 may be partially formed in each step of forming the lower wire structures and partially formed on the uppermost circuit wire line 80, thereby being formed to finally cover the circuit elements 20 and the lower wire structures.

Next, the second substrate 101 may be formed on the peripheral area insulation layer 90. The second substrate 101 may comprise, for example, polycrystalline silicon, and may be formed, for example, by a CVD process. Polycrystalline silicon constituting the second substrate 101 may include an impurity. The second substrate 101 may be smaller than or the same size as the first substrate 11, at least in terms of cross-sectional thickness.

First and second source sacrificial layers 111 and 112 and a second conductive layer 105 may be formed. The first source sacrificial layers 111 may be formed on and under the second source sacrificial layer 112 (the second source sacrificial layer 112 being between two first source sacrificial layers 111). The first source sacrificial layer 111 may be formed of a material having etching selectivity with respect to the second source sacrificial layer 112. For example, the first source sacrificial layer 111 may be formed of a silicon oxide, and the second source sacrificial layer 112 may be formed of a silicon nitride. The second conductive layer 105 may be formed of a semiconductor material.

The base insulation layer 110 may be formed on the second conductive layer 105. The base insulation layer 110 may be formed of, for example, a silicon oxide.

In FIG. 7, it is shown that a first dummy mold structure DS1 is formed so that the first sacrificial insulation layer 180' is disposed on the second conductive layer 105, but is not limited thereto. In some embodiments, the first dummy mold structure DS1 may be formed such that the first interlayer insulating layer 120 is on the second conductive layer 105. In this case, the non-volatile memory device 10 need not include the base insulation layer 110.

The first sacrificial insulation layers 180' may be a layer replaced with first gate electrodes (130, referring to FIG. 2) through a subsequent process (or processes). The first sacrificial insulation layers 180' may comprise a different material from that of the first interlayer insulating layers 120, and may be formed of a material that may be etched with etching selectivity under a specific etch condition for the first interlayer insulating layers 120. For example, the first interlayer insulating layers 120 may include at least one of a silicon oxide and a silicon nitride, and the first sacrificial insulation layers 180' may include a material selected from silicon, a silicon oxide, a silicon carbide, and a silicon nitride and that is different from the first interlayer insulating layers 120. In some embodiments, the thicknesses of the first interlayer insulating layers 120 may not all be the same. The thicknesses of the first interlayer insulating layers 120 and the first sacrificial insulation layers 180' and the number of included layers may be variously changed from those shown.

In the connection area CB of the second substrate 101, the photolithography process and etching process for the first sacrificial insulation layers 180' may be repeatedly performed using a mask layer so that the upper first sacrificial insulation layer 180' extends shorter, in the x direction, than the lower first sacrificial insulation layer 180'. As a result, the first sacrificial insulation layers 180' may form a stair shape (e.g., stepped structure), and pad areas may be provided. Thus, the first dummy mold structure DS1 including the first sacrificial insulation layers 180' and the first interlayer insulating layers 120, which are alternately stacked on the second substrate 101, may be formed.

Next, a first capping insulation layer 190 may be formed, for example, by depositing a first material film covering the first dummy mold structure DS1 on the entire surface of the second substrate 101 and planarizing the first material film (e.g., using a chemical-mechanical planarization/polishing (CMP) process).

The first vertical structures VS1, at a position corresponding to the channel structures CH of FIG. 1, may be formed by proceeding with an etching process to penetrate the first dummy mold structure DS1. First, first penetration holes (i.e., openings) corresponding to (i.e., aligned with) the channel structures CH1 of FIG. 1 may be formed. The first penetration holes may be formed to recess a portion of the second substrate 101.

The first vertical structure VS1 may be formed within the first penetration holes. The first vertical structure VS1 may include a sacrificial barrier metal layer 142 and a sacrificial metal layer 144. The sacrificial barrier metal layer 142 may include titanium. The sacrificial barrier metal layer 142, for example, may include at least one of titanium nitride (TiN), titanium silicon nitride (TiSiN), tantalum titanium nitride (TaTiN), titanium aluminum nitride (TiAIN), titanium aluminum (TiAl), titanium aluminum carbonitride (TiAIC-N), titanium aluminum carbide (TiAIC), titanium carbide (TiC), and a combination thereof. The sacrificial metal layer 144, for example, may include at least one of iridium (Ir), ruthenium (Ru), rhodium (Rh), molybdenum (Mo), copper (Cu), antimony (Sb), aluminum (Al), titanium (Ti), nickel (Ni), tantalum (Ta), zirconium (Zr), hafnium (Hf), tungsten (W), cobalt (Co), and a combination thereof.

The sacrificial barrier metal layer 142 may be formed to at least partially cover the upper surface of the sacrificial metal layer 144. Accordingly, the sacrificial barrier metal layer 142 may be disposed close to the junction between two or more stacking structures. In some embodiments, as shown in FIG. 7, the sacrificial barrier metal layer 142 may be formed to cover the upper surface, side surface, and lower surface of the sacrificial metal layer 144. In some embodiments, the sacrificial barrier layer 142 may be disposed on at least a portion of sidewalls and a bottom surface of the first vertical structure VS1, and then the first vertical structure VS1 may be filled with the sacrificial metal layer 144 (e.g., using a deposition process, such as ALD or CVD).

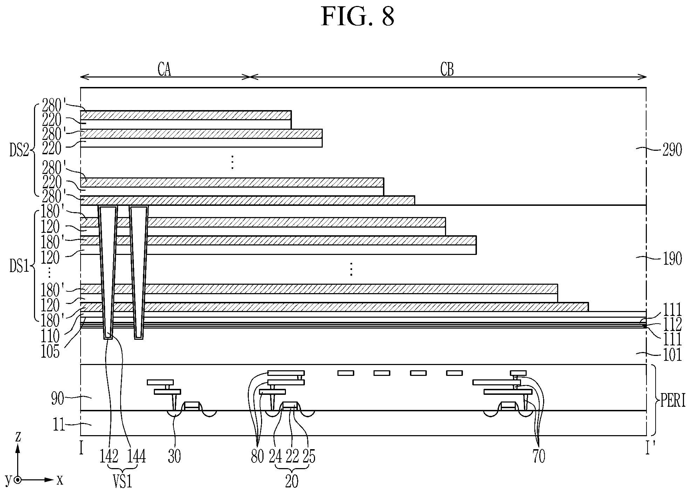

Referring to FIG. 8, second sacrificial insulation layers 280' and second interlayer insulating layers 220 may be alternately stacked in the z direction. The second sacrificial insulation layers 280' may be a layer that is replaced with second gate electrodes (230 in FIG. 2) through a subsequent process. The second sacrificial insulation layers 280' may comprise a different material from that of the second interlayer insulating layers 220, and may be formed of a material that may be etched with etching selectivity under a specific etch condition for the second interlayer insulating layers 220. The second sacrificial insulation layers 280' may be formed of the same material as the first sacrificial insulation layers 180', and the second interlayer insulating layers 220 may be formed of the same material as the first interlayer insulating layers 120, but embodiments of the invention are not limited to such an arrangement.

In the connection area CB of the second substrate 101, the photolithography process and the etching process for the second sacrificial insulation layers 280' may be repeatedly performed using a mask layer so that the upper second sacrificial insulation layer 280' extends shorter (in the x and/or y directions) than the lower second sacrificial insulation layer 280'. As a result, the second sacrificial insulation layers 280' may form a stair (i.e., stepped) shape, and the pad areas may be provided. Thus, a second dummy mold structure DS2 including second sacrificial insulation layers 280' and second interlayer insulating layers 220 alternately stacked on the first dummy mold structure DS1 may be formed.

Next, a second material film covering the second dummy mold structure DS2 may be deposited and the second material film may be planarized to form a second capping insulation layer 290.

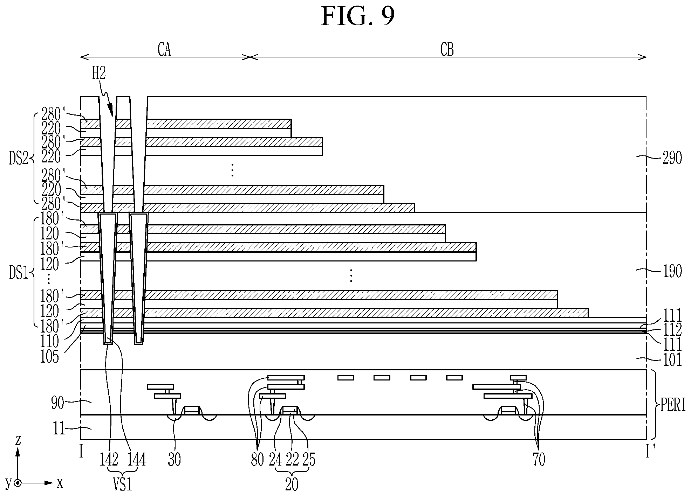

Referring to FIG. 9 to FIG. 13, channel structures CH, including first channel structures CH1 and second channel structures CH2 (see FIGS. 3 - 6), are formed and a planarization process may be performed to planarize the upper surface of the second capping insulation layer 290.

Referring to FIG. 9, at the position (in the x and/or y directions) corresponding to the channel structures CH of FIG. 1, second penetration holes H2 may be formed by performing an etching process to penetrate the second dummy mold structure DS2.

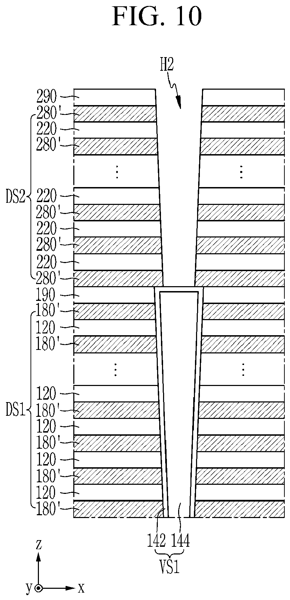

Referring to FIG. 9 and the enlarged view of FIG. 10, when the second penetration hole H2 is formed, which may be by the same method as the first penetration hole, the second penetration hole H2 may have a shape in which the width becomes narrower as it approaches the second substrate 101; that is, sidewalls of the second penetration holes H2 may be inwardly sloped so that the holes narrow in width as they extend toward the second substrate 101 (in the z direction).

However, in the method for fabricating the non-volatile memory device according to one or more embodiments manifesting a technical aspect of the present disclosure, an etching gas capable of forming a by-product capable of etching the second sacrificial insulation layers 280' by reacting with the sacrificial barrier metal layer 142 exposed by the second penetration hole H2 is supplied.

Specifically, by way of example only, when an etching gas containing fluorine (F) is supplied to the second penetration hole H2, it reacts with the sacrificial barrier metal layer 142 including titanium (Ti) to generate titanium fluoride (TiF) as a by-product. The titanium fluoride by-product may etch a part of the second sacrificial insulation layers 280' of the second dummy mold structure DS2. As a result, a part of the second sacrificial insulation layer 280' of the second dummy mold structure DS2 closest to the first dummy mold structure DS1 may be etched, and the lower width of the second penetration hole H2 may be widened.

Referring to FIG. 11 and the enlarged view in FIG. 12, the lower width of the second penetration hole H2 may be widened and then the first vertical structure VS1 (see FIGS. 9 and 10) may be removed. Accordingly, the penetration hole CHH for forming the channel structure may include a first penetration hole of a shape whose width becomes narrower or is maintained as it approaches the second substrate 101, and a second penetration hole H2 including a first portion whose width narrows or is maintained closer to the second substrate 101 and a second portion whose width increases closer to the second substrate 101. The unique shape of the aforementioned channel structure CH is due to the unique shape of the penetration hole CHH for forming the channel structure.

As shown in FIG. 7, when the first vertical structure VS1 includes the sacrificial barrier metal layer 142 formed to cover the upper surface, the side surface, and the lower surface of the sacrificial metal layer 144, an etching gas that does not include fluorine may be used when removing the first vertical structure VS1. Specifically, the etching gas used to remove the first vertical structure VS1 after widening the lower width of the second penetration hole H2, for example, may include at least one of chlorine (Cl₂), bromine (Br₂), Iodine (I₂), a C1-7 alkylchloride, a C1-7 alkylbromide, a C1-7 alkyliodide, a C1-7 trialkylchloride, a C1-7 trialkylbromide, and a C1-7 trialkyliodide, but is not limited thereto.

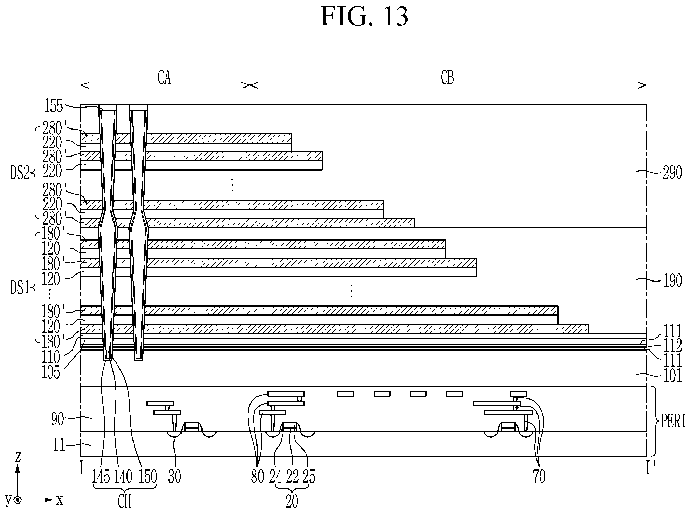

Referring to FIG. 13, the penetration hole CHH for forming the channel structure may be filled to form the channel structure CH. Within the penetration hole CHH for forming the channel structure, as shown in FIG. 2, the channel layer 140, the gate dielectric layer 145, and the channel insulation layer 150 may be formed. In one or more embodiments, the gate dielectric layer 145 may be formed on sidewalls and a bottom of the penetration hole CHH, and the channel layer 140 may be formed on at least a portion of the gate dielectric layer 145. The channel layer 140 and the gate dielectric layer 145 may be formed to have a uniform thickness by using an ALD or CVD process; thicknesses of the gate dielectric layer 145 and channel layer 140 need not be the same. The channel insulation layer 150 may be formed to fill an internal space of the channel layer 140 and may be an insulating material. However, according to some embodiments, the space between the channel layers 140 may be filled with a conductive material instead of the channel insulation layer 150.

After forming the channel structures CH, channel pads 155 may be formed respectively on the channel structures CH.

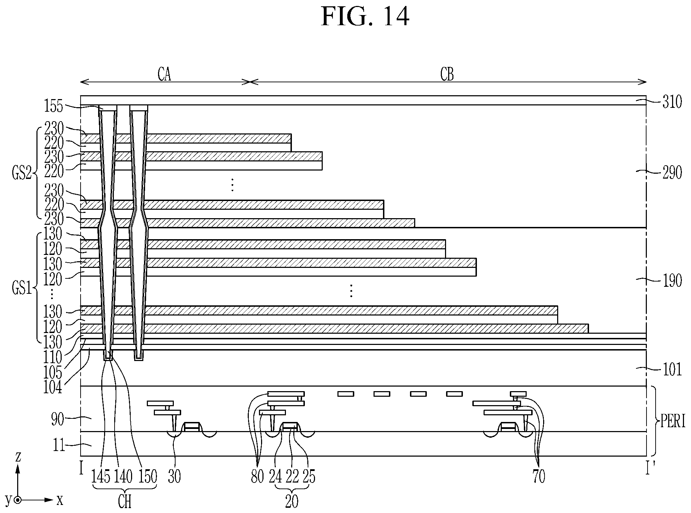

Referring to FIG. 14, first and second gate electrodes 130 and 230 may be formed.

Specifically, the first upper insulation layer 310 may be formed on the channel pads 155 and the second capping insulation layer 290. Then, in the areas corresponding to the separation structure MS (referring to FIG. 1), openings penetrating the first and second dummy mold structures DS1 and DS2 may be formed. The openings may penetrate through the base insulation layer 110, the second conductive layer 105, and the first and second source sacrificial layers 111 and 112 (see FIG. 13) to be formed to recess a portion of the second substrate 101 or to be in contact with the upper surface of the second substrate 101.

Next, after forming a sacrificial spacer layer to protect the first and second dummy mold structures DS1 and DS2 within the opening, the second source sacrificial layer 112 may be selectively removed, and then the first source sacrificial layer 111 may be removed (see FIG. 13). The first and second source sacrificial layers 111 and 112 may be removed by, for example, a wet etching process, although embodiments of the invention are not limited thereto. After forming the first conductive layer 104 by depositing a conductive material in the area where the first and second source sacrificial layers 111 and 112 are removed, the sacrificial spacer layer may be removed in the opening.

Next, the first and second sacrificial insulation layers 180' and 280' (FIG. 13) may be removed through the openings, and the first and second gate electrodes 130 and 230 may be formed by filling with the conductive material. The conductive material may include, for example, a metal, polycrystalline silicon, and/or a metal silicide material. After forming the first and second gate electrodes 130 and 230, the conductive material deposited in the opening may be removed through an additional process, and then the resulting space may be filled with an insulating material.

Next, referring back to FIG. 2, a second upper insulation layer 320 and a third upper insulation layer 330 may be formed on at least a portion of an upper surface of the first upper insulation layer 310, and gate contact plugs CP1, channel contact plugs CP2, and upper wires 355 may be formed.

The gate contact plugs CP1 may be electrically connected to the first and second gate electrodes 130 and 230 in the connection area CB, and the channel contact plugs CP2 may be electrically connected to the channel structures CH. Although not explicitly shown, a substrate contact plug electrically connected to the second substrate 101 may be formed.

The gate contact plugs CP1, the channel contact plugs CP2, and the substrate contact plug may be formed having different depths, but they may be formed by simultaneously forming contact holes by using an etching stop layer and then filling the contact holes with a conductive material. However, in some embodiments, some of the gate contact plugs CP1, the channel contact plugs CP2, and the substrate contact plug may be formed in different process steps.

The upper contact plugs may be formed by forming the third upper insulation layer 330, removing a portion thereof by etching, and filling the removed (etched) portion with conductive material. The bit line 350 and upper wires 355 may be formed by, for example, depositing a conductive material and then patterning it.

As a result, the non-volatile memory devices 10 of FIG. 1 to FIG. 6 may be finally manufactured.

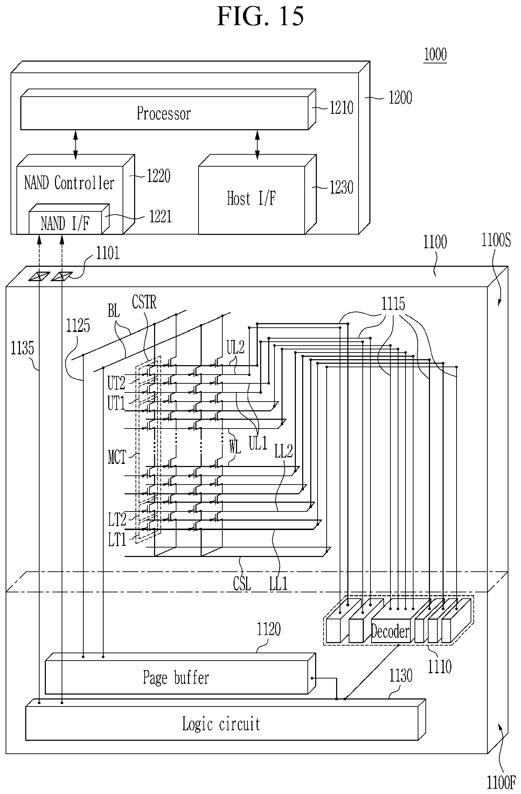

FIG. 15 is a view schematically showing an example electronic system including a semiconductor device according to one or more embodiments of the inventive concept.

Referring to FIG. 15, an electronic system 1000 according to some embodiments may include a semiconductor device 1100 and a controller 1200 electrically connected to the semiconductor device 1100. The electronic system 1000 may be, for example, a storage device including one or a plurality of semiconductor devices 1100 or an electronic device including storage devices. For example, the electronic system 1000 may be a solid-state drive device (SSD device), a universal serial bus (USB), a computing system, a medical device, or a communication device, including one or a plurality of semiconductor devices 1100.

The semiconductor device 1100 may be a non-volatile memory device, for example, a NAND flesh memory device described with reference to FIG. 1 to FIG. 14. The semiconductor device 1100 may include a first structure 1100F and a second structure 1100S on the first structure 1100F. In some embodiments, the first structure 1100F may be disposed next to the second structure 1100S. The first structure 1100F may comprise, for example, a peripheral circuit structure including a decoder circuit 1110, a page buffer 1120, and a logic circuit 1130. The second structure 1100S may be a memory cell structure including one or more bit lines BL, at least one common source line CSL, one or more word lines WL, first and second gate upper lines UL1 and UL2, first and second gate lower lines LL1 and LL2, and memory cell strings CSTR between the bit lines BL and the common source line CSL.

In the second structure 1100S, each of the memory cell strings CSTR may include lower transistors LT1 and LT2 adjacent to the common source line CSL, upper transistors UT1 and UT2 adjacent to the bit lines BL, and a plurality of memory cell transistors MCT between the lower transistors LT1 and LT2 and the upper transistors UT1 and UT2. The number of lower transistors LT1 and LT2 and the number of upper transistors UT1 and UT2 may be variously modified according to embodiments.

In one or more embodiments, the upper transistors UT1 and UT2 may include a string selection transistor, and the lower transistors LT1 and LT2 may include a ground selection transistor. The gate lower lines LL1 and LL2 may be gate electrodes of the lower transistors LT1 and LT2, respectively. The word lines WL may be the gate electrodes of the memory cell transistors MCT, and the gate upper lines UL1 and UL2 may be the gate electrodes of the upper transistors UT1 and UT2, respectively.

The common source line CSL, the first and second gate lower lines LL1 and LL2, the word lines WL, and the first and second gate upper lines UL1 and UL2 may be electrically connected to the decoder circuit 1110 through first connection wires 1115 extending between the second structure 1100S and the first structure 11 00F. The bit lines BL may be electrically connected to the page buffer 1120 through second connection wires 1125 extending between the second structure 1100S and the first structure 1100F.

In the first structure 1100F, the decoder circuit 1110 and the page buffer 1120 may execute a control operation on at least one selection memory cell transistor among a plurality of memory cell transistors MCT. The decoder circuit 1110 and the page buffer 1120 may be controlled by the logic circuit 1130. The semiconductor device 1100 may communicate with the controller 1200 through at least one of an input pad, an output pad, and an input and output pad 1101 electrically connected to the logic circuit 1130. The input and/or output pad 1101 may be electrically connected to the logic circuit 1130 through corresponding input and output connection wires 1135 extending between the second structure 1100S and the first structure 1100F.

The controller 1200 may include a processor 1210, a NAND controller 1220, and a host interface (I/F) 1230. According to some embodiments, the electronic system 1000 may include a plurality of semiconductor devices 1100, and in this case, the controller 1200 may control a plurality of semiconductor devices 1100.

The processor 1210 may control the overall operation of the electronic system 1000 including the controller 1200. The processor 1210 may operate according to predetermined firmware, and may access the semiconductor device 1100 by controlling the NAND controller 1220. The NAND controller 1220 may include a NAND interface 1221 that processes communications with the semiconductor device 1100. For example, through the NAND interface 1221, control instructions for controlling the semiconductor device 1100, data to be written to the memory cell transistors MCT of the semiconductor device 1100, and data to be read from the memory cell transistors MCT of the semiconductor device 1100, etc., may be conveyed. Although not explicitly shown (but implied), the host interface 1230 may provide a communication function between the electronic system 1000 and an external host. When a control instruction is received from an external host through the host interface 1230, the processor 1210 may control the semiconductor device 1100 in response to the control instruction.

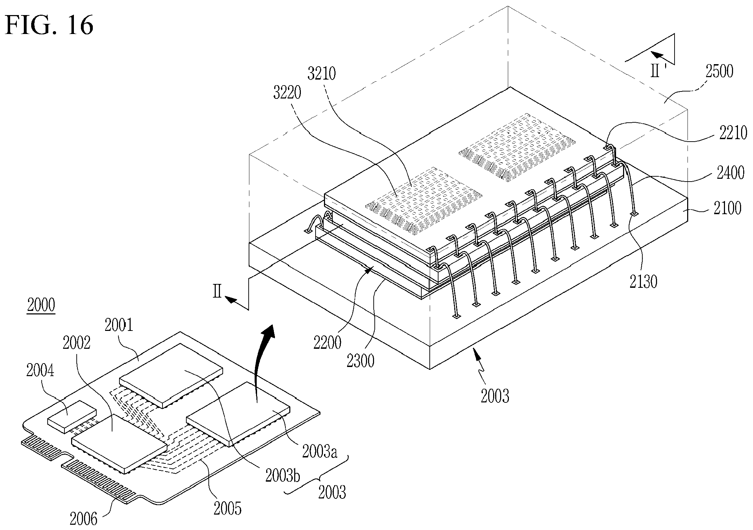

FIG. 16 is a perspective view schematically illustrating an example electronic system including a semiconductor device according to one or more embodiments of the inventive concept.

Referring to FIG. 16, an electronic system 2000 according to one or more embodiments may include a main substrate 2001, a controller 2002 mounted on the main substrate 2001, and at least one semiconductor package 2003 and a DRAM 2004 disposed on the main substrate 2001. The semiconductor package 2003 and the DRAM 2004 may be connected to the controller 2002 by wire patterns 2005 disposed on the main substrate 2001.

The main substrate 2001 may include a connector 2006 including a plurality of pins (e.g., along an edge of the main substrate 2001) adapted for connection to an external host. The number and arrangement of the plurality of pins in the connector 2006 may vary depending on the communication interface between the electronic system 2000 and the external host. In some embodiments, the electronic system 2000 may communicate with the external host according to any one among interfaces such as a USB (Universal Serial Bus), a PCI-Express (Peripheral Component Interconnect Express), a SATA (Serial Advanced Technology Attachment), a UFS (Universal Flash Storage) M-Phy, etc. In some embodiments, the electronic system 2000 may be operated by power supplied from an external host through the connector 2006. The electronic system 2000 may further include a power management integrated circuit (PMIC) that distributes the power supplied from the external host to other components on the main substrate 2001, such as the controller 2002 and the semiconductor package 2003.

The controller 2002 may write data to the semiconductor package 2003 or read data from the semiconductor package 2003, and improve the operation speed of the electronic system 2000.

The DRAM 2004 may be a buffer memory for mitigating a speed difference between the semiconductor package 2003, which may include a data storage space, and an external host. The DRAM 2004 included in the electronic system 2000 may also operate as a kind of a cache memory, and may provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other on the main substrate 2001. The first and second semiconductor packages 2003a and 2003b may each be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on each bottom surface of the semiconductor chips 2200, a connection structure 2400 electrically connecting the semiconductor chips 2200 and the package substrate 2100, and a molding layer 2500 covering the semiconductor chips 2200 and the connection structure 2400 on the package substrate 2100.

The package substrate 2100 may be a printed circuit board (PCB) including package upper pads 2130. Each semiconductor chip 2200 may include at least one input and/or output pad 2210. The input and/or output pad 2210 may, for example, correspond to the input and/or output pad 1101 of FIG. 15. Each of the semiconductor chips 2200 may include memory stacking structures 3210 and channel structures 3220. Each of the semiconductor chips 2200, referring to FIG. 1 to FIG. 14, may include the above-described non-volatile memory device.

In some embodiments, the connection structure 2400 may comprise one or more bonding wires and/or other connection means (e.g., C4 solder balls or bumps, ball grid array (BGA), etc.) electrically connecting the input and/or output pad 2210 to corresponding package upper pads 2130. Accordingly, in each of the first and second semiconductor packages 2003a and 2003b, the semiconductor chips 2200 may be electrically connected to each other by using a bonding wire method, and may be electrically connected to the package upper pads 2130 of the package substrate 2100. According to some embodiments, in each of the first and second semiconductor packages 2003a and 2003b, the semiconductor chips 2200 may be electrically connected to each other by a connection structure including a through electrode (a through silicon via, TSV) instead of, or in addition to, the bonding wire type of connection structure 2400.

In some embodiments, the controller 2002 and the semiconductor chips 2200 may be included in one package. In an embodiment, the controller 2002 and the semiconductor chips 2200 may be mounted on a separate interposer substrate different from the main substrate 2001, and the controller 2002 and the semiconductor chips 2200 may be connected to each other by a wire formed on or in the interposer substrate.

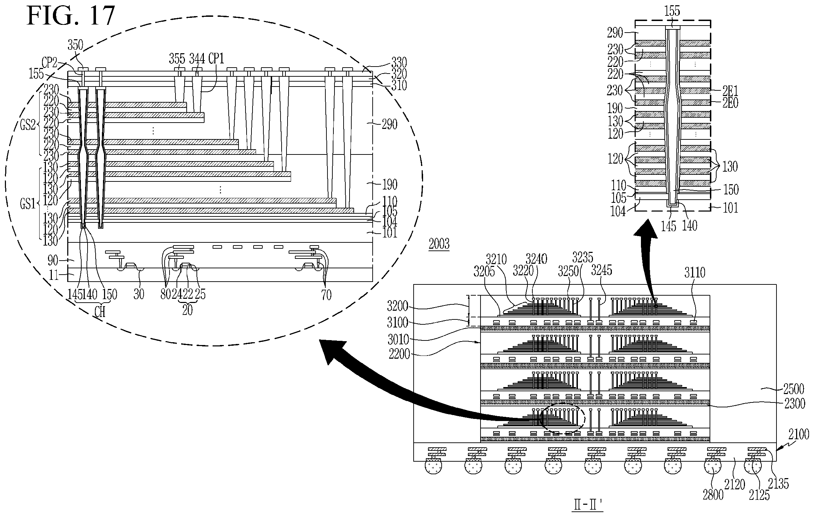

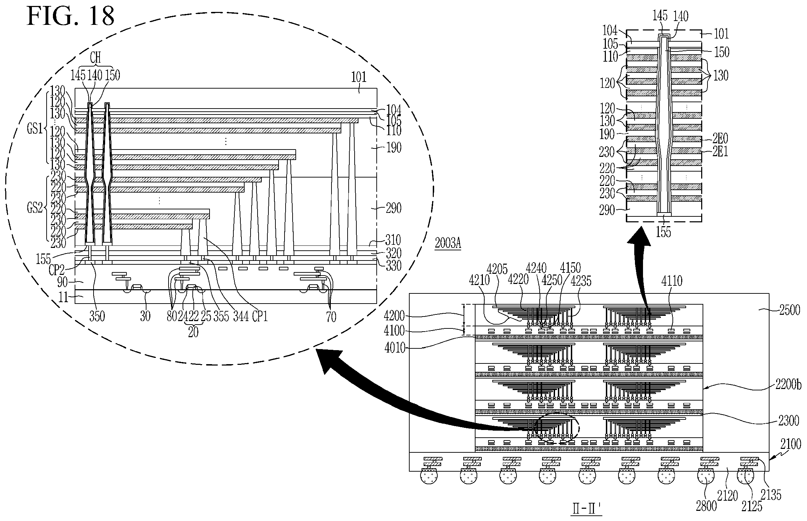

FIG. 17 and FIG. 18 are cross-sectional views schematically showing a semiconductor package according to one or more embodiments of the inventive concept. FIG. 17 and FIG. 18 respectively explain the embodiment of the semiconductor package 2003 of FIG. 16, and conceptually represent an area obtained by cutting the semiconductor package 2003 of FIG. 16 along the cutting line II-II'.

Referring to FIG. 17, in the semiconductor package 2003, the package substrate 2100 may be a printed circuit board (PCB). The package substrate 2100 may include a package substrate body portion 2120, package upper pads (2130 of FIG. 16) disposed on the upper surface of the package substrate body portion 2120, lower pads 2125 disposed on the lower surface of the package substrate body portion 2120 and exposed through the lower surface, and internal wires 2135 electrically connecting upper pads (2130 of FFIG. 16) and the lower pads 2125 inside the package substrate body portion 2120. The upper pads (2130 of FIG. 16) may be electrically connected to the connection structures 2400 (FIG. 16). The lower pads 2125 may be connected to the wire patterns 2005 of the main substrate 2001 of the electronic system 2000 through conductive connection parts 2800, as shown in FIG. 16.

Each of the semiconductor chips 2200 may include a semiconductor substrate 3010, and a first structure 3100 and a second structure 3200 sequentially stacked on the semiconductor substrate 3010. The first structure 3100 may include a peripheral circuit area including circuit wire lines 3110. The second structure 3200 may include a common source line 3205, a memory stacking structure 3210 on the common source line 3205, channel structures 3220 and separation structures (MS of FIG. 1) passing through the memory stacking structure 3210, bit lines 3240 electrically connected to the channel structures 3220, and gate contact plugs 3235 electrically connected to word lines (WL of FIG. 15) of the memory stacking structure 3210.

The memory stacking structure 3210 may include a first stacking structure GS1 and a second stacking structure GS2 stacked on the first stacking structure GS1, and the channel structures CH may include a first channel structure CH1 passing through the first stacking structure GS1 and a second channel structure CH2 passing through the second stacking structure (see, e.g., FIGS. 3 - 6). The channel structures CH may have a wide width in a region where a plurality of stacking structures GS1 and GS2 are joined, as previously described.

The semiconductor chips 2200 may include at least one through plug 3245 electrically connected to the corresponding circuit wire lines 3110 of the first structure 3100, respectively, and extending into the second structure 3200.

The through plug 3245 may be disposed outside the memory stacking structure 3210, and may be further disposed to pass through the memory stacking structure 3210. Each of the semiconductor chips 2200 may further include an input and/or output pad (2210 of FIG. 16) electrically connected to the circuit wire lines 3110 of the first structure 3100.

Referring to FIG. 18, in the semiconductor package 2003A, each of the semiconductor chips 2200b may include a semiconductor substrate 4010, a first structure 4100 on the semiconductor substrate 4010, and a second structure 4200 joined to the first structure 4100 by a wafer bonding method or other connection means (e.g., solder balls/bumps, BGA, etc.) on the first structure 4100.

The first structure 4100 may include a peripheral circuit area including circuit wire lines 4110 and first junction structures 4150. The second structure 4200 may include a common source line 4205, a memory stacking structure 4210 between the common source line 4205 and the first structure 4100, channel structures 4220 and a separation structure (MS of FIG. 1) penetrating the memory stacking structure 4210, and second junction structures 4250 electrically connected to the channel structures 4220 and word lines (WL of FIG. 15) of the memory stacking structure 4210, respectively. For example, the second junction structures 4250 may be electrically connected to the channel structures 4220 and the word lines (WL of FIG. 15) through bit lines 4240 electrically connected to the channel structures 4220 and gate contact plugs 4235 electrically connected to the word lines (WL of FIG. 1), respectively. The first junction structures 4150 of the first structure 4100 and the second junction structures 4250 of the second structure 4200 may be joined while being in contact with each other. The joined parts of the first junction structures 4150 and the second junction structures 4250 may be formed of, for example, copper (Cu).

The memory stacking structure 4210 may include a first stacking structure GS1 and a second stacking structure GS2 disposed under the first stacking structure GS1, and the channel structures CH may include a first channel structure CH1 penetrating the first stacking structure GS1 and a second channel structure CH2 penetrating the second stacking structure GS2 (see, e.g., FIGS. 3 - 6). The channel structures CH may have a wide width in a region where a plurality of stacking structures GS1 and GS2 are joined, as previously described.

Each of the semiconductor chips 2200b may further include at least one input and/or output pad (2210 of FIG. 16) electrically connected to the circuit wire lines 4110 of the first structure 4100.

The semiconductor chips 2200 of FIG. 17 and the semiconductor chips 2200b of FIG. 18 may be electrically connect to each other by connection structures 2400 of a bonding wire type. However, in some embodiments, semiconductor chips within one semiconductor package, such as the semiconductor chips 2200 of FIG. 17 and the semiconductor chips 2200b of FIG. 18, may be electrically connected to each other by a connection structure including a through electrode (e.g., a through silicon via, TSV).

It will be understood that the terms "comprises" and/or "comprising," when used in this specification, specify the presence of stated features, steps, operations, elements, and/or components, but do not preclude the presence or addition of one or more other features, steps, operations, elements, components, and/or groups thereof. Spatially descriptive terms such as "above," "below," "upper" and "lower" may be used herein to indicate a position of elements, structures or features relative to one another as illustrated in the figures, rather than absolute position. Thus, the semiconductor device may be otherwise oriented (e.g., rotated 90 degrees or at other orientations), and the spatially relative descriptions used herein may be interpreted accordingly.

It will also be understood that when an element such as a layer, region or substrate is referred to as being "atop," "above," "on" or "over" another element, it is broadly intended that the element be in direct contact with the other element or intervening elements can also be present. In contrast, when an element is referred to as being "directly on" or "directly over" another element, it is intended that there are no intervening elements present. Likewise, it should be appreciated that when an element is referred to as being "connected" or "coupled" to another element, it can be directly connected or coupled to the other element or intervening elements can be present. In contrast, when an element is referred to as being "directly connected" or "directly coupled" to another element, there are no intervening elements present.

While the inventive concept has been particularly shown and described with reference to embodiments thereof, it will be understood that various changes in form and details may be made therein by a person of ordinary skill in the art given the teachings herein without departing from the scope of the following claims.

## Claims

1. A non-volatile memory device, comprising:
a first stacking structure including first gate electrodes and first interlayer insulating layers alternately stacked on at least a portion of a substrate;
a second stacking structure including second gate electrodes and second interlayer insulating layers alternately stacked on at least a portion of the first stacking structure; and
a channel structure including a first channel structure penetrating the first stacking structure and a second channel structure connected to the first channel structure and penetrating the second stacking structure,
wherein the second channel structure includes a first portion having a width that narrows or is maintained as the first portion extends toward the substrate, and a second portion having a width that increases as the second portion extends toward the substrate in an area overlapping a lowermost one of the second gate electrodes that is disposed closest to the substrate in a vertical direction to the substrate.

2. The non-volatile memory device of claim 1, wherein the second channel structure includes the second portion of which the width increases as it extends toward the substrate in the area overlapping a lower second gate electrode most adjacent to the lowermost one of the second gate electrodes in a vertical direction to the substrate.

3. The non-volatile memory device of claim 1 or 2, wherein the channel structure includes a third portion having a width that increases as the third portion extends toward the substrate.

4. The non-volatile memory device of claim 3, wherein the first portion of the channel structure is disposed on or under the third portion of the channel structure.

5. The non-volatile memory device of claim 3 or 4, wherein a widest width of the second portion of the channel structure is less or greater than a widest width of the third portion of the channel structure.

6. The non-volatile memory device of claim 3, 4 or 5, wherein the channel structure includes a channel layer, and a thickness of the channel layer in the second portion of the channel structure is different from a thickness of the channel layer in the first or third portions of the channel layer.

7. The non-volatile memory device of any one of claims 1 to 6, further comprising a common source line disposed on at least a portion of the substrate, wherein the channel structure includes a channel layer that is connected to the common source line.

8. The non-volatile memory device of any one of claims 1 to 7, further comprising:
two or more second stacking structures stacked sequentially on the first stacking structure in a direction perpendicular to a surface of the substrate; and
a plurality of second channel structures of the channel structure penetrating the two or more second stacking structures,
wherein the first channel structure of the channel structure penetrating the first stacking structure is connected to the plurality of second channel structures.

9. The non-volatile memory device of claim 8, wherein each of at least a subset of the plurality of second channel structures includes a first portion having a width that narrows or is maintained as the first portion extends toward the substrate, and a second portion having a width that increases as the second portion extends toward the substrate in the area overlapping the lowermost one of the second gate electrodes that is disposed closest to the substrate in the vertical direction to the substrate.

10. A method for fabricating a non-volatile memory device, the method comprising:
forming a first dummy mold structure in which first sacrificial insulation layers and first interlayer insulating layers are alternately stacked on at least a portion of a substrate;
forming a vertical structure penetrating the first dummy mold structure;
forming a second dummy mold structure in which second sacrificial insulation layers and second interlayer insulating layers are alternately stacked on the first dummy mold structure and the vertical structure; and
forming a hole in the second dummy mold structure for forming a channel structure in the hole and removing the vertical structure,
wherein the vertical structure includes a sacrificial metal layer and a sacrificial barrier metal layer on at least part of an upper surface of the sacrificial metal layer, and
the forming of the hole includes supplying an etching gas capable of forming a by-product for etching the second sacrificial insulation layers by reacting with the sacrificial barrier metal layer.

11. The method of claim 10, further comprising, after forming the second dummy mold structure, repeatedly performing: (i) forming a vertical structure penetrating the second dummy mold structure; and (ii) forming another second dummy mold structure on the second dummy mold structure and the vertical structure.

12. The method of claim 10 or 11, wherein the second sacrificial insulation layers include a silicon nitride.

13. The method of claim 10, 11 or 12, wherein the sacrificial barrier metal layer includes titanium.

14. The method of any one of claims 10 to 13, wherein the etching gas includes fluorine.

15. An electronic system, comprising:
a semiconductor device on a main substrate; and
a controller electrically connected to the semiconductor device on the main substrate,
wherein the semiconductor device includes a non-volatile memory device as claimed in any one of claims 1 to 9, the non-volatile memory device further including:
a substrate,
a peripheral circuit substrate disposed under the substrate,
a peripheral circuit pattern disposed on at least a portion of the peripheral circuit substrate,
a peripheral area insulation layer on at least a portion of the peripheral circuit pattern, and
an input and output pad electrically connected to the peripheral circuit pattern of the non-volatile memory device.
